# FASCICULE DE BREVET EUROPEEN

(11) **EP 0 741 678 B1**
(45) Date de publication et mention de la délivrance du brevet: **19.05.1999**
(21) Numéro de dépôt: 95907684.5
(22) Date de dépôt: 19.01.1995
(51) Int. Cl.: C04B 35/45

(54) **MATERIAU SUPRACONDUCTEUR ET PROCEDE DE PREPARATION DE MATERIAUX SUPRACONDUCTEURS**
SUPRALEITENDER WERKSTOFF UND VERFAHREN ZUR HERSTELLUNG DESSELBEN
SUPERCONDUCTING MATERIAL AND METHOD FOR PREPARING SUPERCONDUCTING MATERIALS

(30) Priorité: 26.01.1994 FR 9401097
(43) Date de publication de la demande: 13.11.1996
(73) Titulaire: ALCATEL, 75008 Paris (FR)
(72) Inventeur: ALARIO-FRANCO, Miguel, Angel, F-38000 Grenoble (FR); CHAILLOUT, Catherine, F-38960 Saint-Etienne-de-Crossey (FR); CAPPONI, Jean-Jacques, F-38610 Gières (FR); THOLENCE, Jean-Louis, F-38330 Montbonnot-Saint-Martin (FR); SOULETIE, Bénédicte, F-38000 Grenoble (FR)
(74) Mandataire: Laroche, Danièle
(86) Numéro de dépôt international: FR9500059
(87) Numéro de publication internationale: WO9520550

(56) Documents cités:
- EP-A- 0 660 424
- JAPANESE JOURNAL OF APPLIED PHYSICS, vol.33, no.3A, 1 Mars 1994 pages L333 - L303 H.IHARA ET AL.
- PHYSICA C, vol.223, 1994 pages 243 - 248 WU ET AL.
- PHYSICA C, vol.224, 1994 pages 175 - 178 WU ET AL.

## Description

La présente invention concerne les supraconducteurs de type céramique à température critique élevée.

On connaît des supraconducteurs du système Ba-Ca-Cu-O tels que les familles ABa₂Caₙ₋₁CuₙOₓ où n est un entier supérieur à 1, x est supérieur à 2n+2, et A est du mercure ou du thallium. Ces matériaux présentent des températures critiques élevées, supérieures à 100 K pour certaines phases, c'est-à-dire certaines valeurs de n. Cette température critique augmente quand le matériau est utilisé à pression élevée. Pour le mercure et le thallium, il a été constaté que la température critique augmente à l'intérieur d'une famille donnée avec la valeur de n jusqu'à n=3 et diminue ensuite.

Ces matériaux sont fabriqués sous forme de céramiques en soumettant un mélange de précurseurs, en proportion sensiblement stoechiométrique avec un excès d'oxygène, à des températures et des pressions élevées.

Nonobstant les propriétés très intéressantes présentées par les composés du type Hg-Ba-Ca-Cu-O et Tl-Ba-Ca-Cu-O, les recherches se poursuivent pour trouver d'autres céramiques supraconductrices à température critique élevée, d'une part dans l'espoir d'atteindre des températures critiques encore plus élevées, d'autre part dans le but d'éviter d'utiliser des corps fortement toxiques tels que le thallium et, à un degré moindre mais non négligeable, le mercure.

Ainsi, la présente invention prévoit un matériau supraconducteur de la famille A-Ba-Ca-Cu-O dans lequel A est du cuivre. D'autre part, la présente invention propose un procédé de fabrication de céramiques supraconductrices partant d'un précurseur de type Ba-Ca-Cu-O, en proportion sensiblement stoechiométrique pour la formation de CuBa₂Caₙ₋₁CuₙOₓ et d'oxyde d'argent. On obtient ainsi une céramique supraconductrice comprenant des grains de composés ayant la formule susvisée et des grains métalliques d'argent. Néanmoins, il n'est pas exclu dans l'état actuel des recherches que des atomes d'argent soient présents dans les grains supraconducteurs et contribuent à l'obtention des qualités supraconductrices du composé qui seront exposées ci-après.

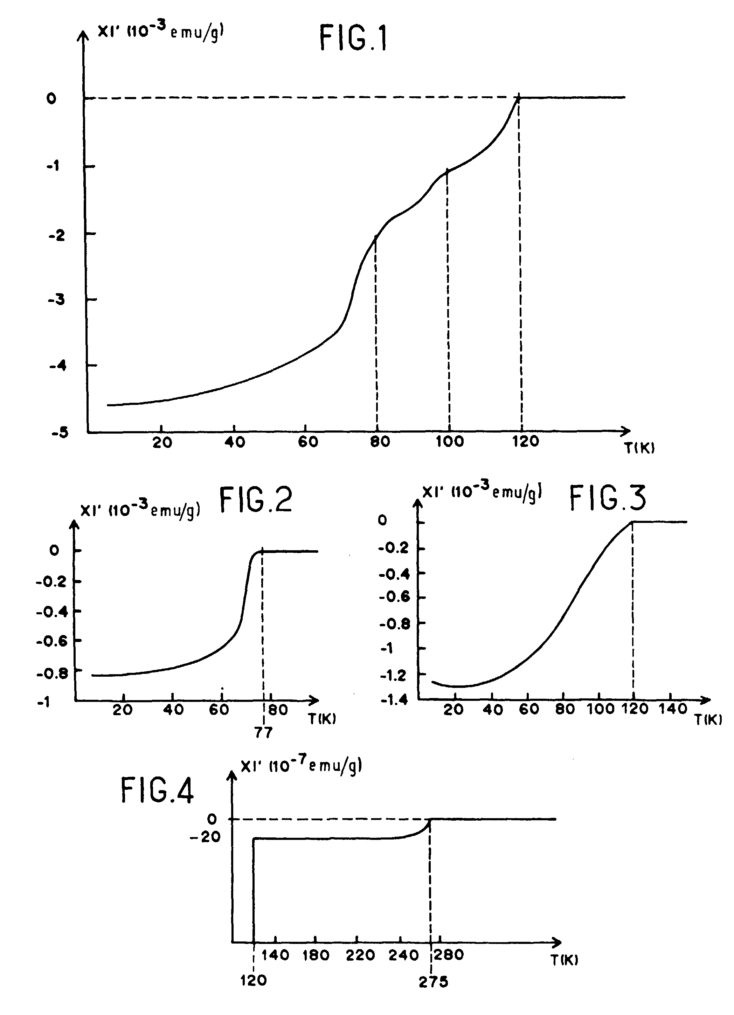

Ces objets, caractéristiques et avantages ainsi que d'autres de la présente invention seront exposés en détail dans la description suivante de modes de réalisation particuliers faite en relation avec les figures 1 à 4 jointes qui représentent des courbes de susceptibilité magnétique en fonction de la température pour des corps obtenus par le procédé selon la présente invention.

Les inventeurs ont préparé des échantillons de céramique à haute pression (supérieure à 4 GPa) et haute température (850 à 1000°C et de préférence 900 à 950°C) en utilisant un appareil de mise sous pression de type belt. Un précurseur de composition nominale Ba₂Caₙ₋₁Cuₙ₊₁Oₓ ou Ba₂Caₙ₋₁CuₙOₓ a été préparé de la façon indiquée dans l'article de Antipov et al., Physica C, 215, 1 (1993). Plus généralement, ce précurseur peut être obtenu en mélangeant des composés oxydés sous forme de poudre tels que des oxydes, des nitrates ou des carbonates de baryum, calcium et cuivre dans les proportions visées, cette opération étant réalisée sous une atmosphère d'oxygène à pression atmosphérique à une température de 850 à 950°C pendant plusieurs heures. Le précurseur obtenu est hygroscopique et doit être conservé en atmosphère d'oxygène ou en atmosphère neutre.

Parallèlement, on a synthétisé de l'oxyde d'argent, AgO ou Ag₂O ou un mélange de ces oxydes.

L'oxyde d'argent et le précurseur (et éventuellement un excès d'oxyde de cuivre) ont été finement broyés et mélangés avant d'être disposés dans le système de synthèse susmentionné.

Classiquement, la pression a d'abord été augmentée jusqu'à une valeur de l'ordre de 5 GPa puis la température a été augmentée jusqu'à la valeur désirée en sensiblement une heure. Après cela, la température et la pression ont été maintenues pendant plus d'une heure.

Après mise à température et pression normale, on a obtenu un bloc de céramique comprenant des grains d'une dimension de l'ordre de la centaine de micromètres qui ont été identifiés par diffraction aux rayons X comme étant constitués de diverses phases de CuBa₂Caₙ₋₁CuₙOₓ où n était compris entre 1 et 6. Il est néanmoins possible qu'il existe également dans le matériau obtenu des membres de la famille où n est supérieur à 6. Le bloc obtenu contenait également des grains d'argent ou de composés d'argent d'une dimension inférieure à 10 micromètres. On peut donc considérer que l'argent a essentiellement servi de catalyseur pour l'obtention de CuBa₂Caₙ₋₁CuₙOₓ bien qu'il ne soit pas exclu qu'il demeure en très faible proportion dans chacun des grains de céramique des atomes d'argent jouant éventuellement un rôle dans les propriétés supraconductrices. En gros, indépendamment de la présence des grains d'argent, on obtient une structure sensiblement telle que décrite par S.N. Putilin et al. dans Nature 362, 226 (1993) et E.V. Antipov et al. dans Physica C, 215, 1 (1993) mais où le mercure est remplacé par du cuivre.

### Exemple 1

On a préparé un composé selon les indications générales ci-dessus dans lequel, plus particulièrement, la phase de préparation de céramique à haute pression était réalisée sous une pression de 4 GPa (40 kbars) à une température de 850°C pendant une heure et demi.

Le précurseur était sous forme de poudre finement broyée de Ba₂Ca₂Cu₃Oₓ et une unité de précurseur a été mélangée à deux unités d'oxyde d'argent AgO, également sous forme de poudre.

Les mesures de susceptibilité magnétiques effectuées sur le corps obtenu sont illustrées en figure 1. On obtient une susceptibilité magnétique XI' en unité électromagnétique (emu/g) telle qu'illustrée en figure 1. On voit que le diamagnétisme reste nul jusqu'à sensiblement 120 K, qu'un diamagnétisme apparaît sensiblement pour 120 K et que la courbe de diamagnétisme présente des décrochements à environ 95 et 77 K. Ceci indique que la céramique obtenue contient trois composés supraconducteurs ayant respectivement des températures critiques de 120, 95 et 77 K.

Bien que cela n'ait pas encore été prouvé de façon certaine, les inventeurs supposent que ces trois températures critiques correspondent à des composés pour lesquels les valeurs de n correspondent vraisemblablement à 3, 4, 5, ou 6.

### Exemple 2

Dans les mêmes conditions de pression et de température que dans l'exemple 1, on a utilisé comme précurseur Ba₂Ca₂Cu₃Oₓ et une proportion de précuseur a été mélangée à deux proportions d'AgO et à une proportion de CuO.

La courbe de susceptibilité magnétique en fonction de la température est indiquée en figure 2. On aperçoit une transition supraconductrice pour une température de 77 K, la phase du composé supraconducteur ayant été identifiée comme la phase pour laquelle n=3.

### Exemple 3

Dans les mêmes conditions de pression et de température que dans l'exemple 1, on a utilisé comme précurseur Ba₂Ca₂Cu₃Oₓ qui a été mélangé à une proportion de Ag₂O.

La courbe de susceptibilité magnétique en fonction de la température est donnée par la figure 3. On voit que la transition supraconductrice apparait pour une température de 120 K. Dans l'état actuel des mesures, on suppose que ce composé correspond à la phase n=4 ou 5.

### Exemple 4

Dans les mêmes conditions de pression et de température que dans l'exemple 1, on a utilisé comme précurseur Ba₂Ca₂Cu₄Oₓ qui a été mélangé à deux proportions d'AgO.

La courbe de susceptibilité magnétique, illustrée en figure 4 présente comme celle de la figure 3 une transition marquée à 120 K. Néanmoins, en considérant à échelle beaucoup plus agrandie cette susceptibilité magnétique, on note qu'un décrochement apparaît à une température de 275 K, c'est-à-dire +2°C. Des expériences similaires à haute sensibilité n'ont pas été effectuées pour les échantillons des figures 1, 2 et 3 et il n'est pas exclu que des résultats similaires apparaissent aussi pour ces échantillons.

La phase à laquelle correspond le matériau présentant cette température critique très élevée n'a pas été identifiée avec précision mais on considère aujourd'hui qu'il s'agit d'un matériau pour lequel la phase n est élevée (de l'ordre de 6 ou plus). D'autre part, cette valeur élevée de la température critique peut être due au maintien d'atomes d'argent à l'intérieur de la phase supraconductrice.

Ainsi, le procédé selon la présente invention permet d'obtenir un composé supraconducteur dont la formule principale est CuBa₂Caₙ₋₁CuₙOₓ mais plus généralement, la présente invention vise tout corps obtenu par le procédé décrit consistant à fabriquer une céramique sous haute pression et haute température à partir d'un précurseur ou d'un mélange de précurseurs de Ba₂Caₙ₋₁Cuₙ₊₁Oₓ en présence d'argent pour fournir un matériau supraconducteur à température critique élevée. Ce composé peut comprendre un excès de calcium et un défaut de baryum selon la formule CuBa_{2-y}Ca_{n-1+y}CuₙOₓ où y est compris entre 0 et 0,5.

On notera que la composition du précurseur peut être modifiée et n'est pas nécessairement strictement stoechiométrique. De même, on pourra prévoir des quantités variables d'oxyde d'argent, couramment dans une plage d'une à trois moles d'oxyde d'argent pour une mole de précurseur.

## Revendications

1. Procédé de préparation d'un matériau supraconducteur caractérisé en ce qu'il comprend les étapes suivantes :
préparer un précurseur constitué d'une poudre de Ba₂Caₙ₋₁Cuₙ₊₁Oₓ ou Ba₂Caₙ₋₁CuₙOₓ où n est un entier supérieur à 1 et x est supérieur à 2n+2,
mélanger cette poudre à de la poudre d'oxyde d'argent, éventuellement en présence d'un excès d'oxyde de cuivre, dans une proportion d'une mole de précurseur pour une à trois moles d'oxyde d'argent,
chauffer à haute température et haute pression.

2. Procédé de préparation selon la revendication 1, caractérisé en ce que le précurseur est constitué à partir de composés oxydés tels qu'oxyde, nitrate ou carbonate de baryum, calcium et cuivre dans les proportions visées, chauffés sous oxygène à pression atmosphérique pendant plusieurs heures.

3. Procédé selon la revendication 1, caractérisé en ce que l'oxyde d'argent est du type AgO ou Ag₂O.

4. Procédé selon la revendication 1, caractérisé en ce que l'étape de chauffage à haute température et haute pression est réalisée à une pression supérieure à environ 4 GPa et à une température supérieure à 850°C.

5. Procédé selon la revendication 4, caractérisé en ce que ladite température est inférieure à 1000°C.

6. Procédé selon la revendication 4, caractérisé en ce que ladite température est voisine de 900°C.

7. Matériau supraconducteur du type ABa₂Caₙ₋₁CuₙOₓ où n est un entier supérieur à 1 et où x est supérieur à 2n+2, caractérisé en ce que A est du cuivre et en ce qu'il comprend des traces d'argent.

8. Matériau supraconducteur selon la revendication 7, caractérisé en ce que n est supérieur ou égal à 3.

9. Matériau supraconducteur selon la revendication 7, caractérisé en ce qu'il comprend un excès de calcium et un défaut de baryum selon la formule CuBa_{2-y}Ca_{n-1+y}CuₙOₓ où y est compris entre 0 et 0,5.

## Patentansprüche

1. Verfahren zur Herstellung eines supraleitfähigen Materials,
**dadurch gekennzeichnet, daß** es die folgenden Schritte umfaßt:
Herstellen eines Zwischenstoffs, der aus einem Pulver aus Ba₂Caₙ₋₁Cuₙ₊₁Oₓ oder Ba₂Caₙ₋₁CuₙOₓ, wobei n eine ganze Zahl größer, als l ist und x größer, als 2n +2 ist, gebildet wird,
Mischen dieses Pulvers mit pulverigem Silberoxid, gegebenenfalls in Gegenwart eines Überschuß an Kupferoxid, in einem Verhältnis von einem Mol Zwischenstoff pro einem bis drei Mol Silberoxid,
Erhitzen auf hohe Temperatur und Anlegen hohen Druckes.

2. Herstellverfahren nach Anspruch 1,
**dadurch gekennzeichnet, daß** der Zwischenstoff, ausgehend von Oxidverbindungen, wie Oxide, Nitrate oder Carbonate von Barium, Calcium und Kupfer, in den vorgesehenen Anteilen, gebildet wird und unter Sauerstoff bei Umgebungsdruck für mehrere Stunden erhitzt wird.

3. Verfahren nach Anspruch 1,
**dadurch gekennzeichnet, daß** das Silberoxid AgO oder Ag₂O ist.

4. Verfahren nach Anspruch 1,
**dadurch gekennzeichnet, daß** der Schritt zur Erwärmung auf hohe Temperatur und Anlegen eines hohen Druckes bei einem Druck oberhalb von ungefähr 4 GPa und einer Temperatur oberhalb von 850 °C durchgeführt wird

5. Verfahren nach Anspruch 4,
**dadurch gekennzeichnet, daß** die genannte Temperatur unterhalb von 1000 °C liegt.

6. Verfahren nach Anspruch 4,
**dadurch gekennzeichnet, daß** die genannte Temperatur um 900 °C liegt.

7. Supraleitfähiges Material von der Art ABa₂Caₙ₋₁CuₙOₓ, wobei n eine ganze Zahl größer, als 1 ist und wobei x größer, als 2n+2 ist,
**dadurch gekennzeichnet, daß** A Kupfer ist, und daß es Spuren von Silber enthält.

8. Supraleitfähiges Material nach Anspruch 7,
**dadurch gekennzeichnet, daß** n größer, oder gleich 3 ist.

9. Supraleitfähiges Material nach Anspruch 7,
**dadurch gekennzeichnet, daß** es einen Überschuß an Calcium und einen Mangel an Barium gemäß der Formel CuBa_{2-y}Ca_{n-1+y}CuₙOₓ, wobei y zwischen 0 und 0,5 enthalten ist, aufweist.

## Claims

1. A method of preparing a superconductor material characterized in that it comprises the following steps:
preparing a precursors constituted by a powder of Ba₂Caₙ₋₁Cuₙ₊₁Oₓ or Ba₂Caₙ₋₁CuₙOₓ where n is an integer greater than 1 and x is greater than 2n+2;
mixing said powder with silver oxide power, optionally in the presence of excess copper oxide, in a proportion of one mole of precursor for one to three moles of silver oxide; and
heating to high temperature and high pressure.

2. A method of preparation according to claim 1, characterized in that the precursor is made up from oxidized compounds such as the oxide, nitrate, or carbonate of barium, calcium, or copper in the specified proportions, and heated under oxygen at atmospheric pressure for several hours.

3. A method according to claim 1, characterized in that the silver oxide is of the AgO or the Ag₂O type.

4. A method according to claim 1, characterized in that the step of heating to high temperature and high pressure is performed at a pressure greater than about 4 GPa and at a temperature greater than 850°C.

5. A method according to claim 4, characterized in that said temperature is less than 1000°C.

6. A method according to claim 4, characterized in that said temperature is close to 900°C.

7. A superconductor material of the ABa₂Caₙ₋₁CuₙOₓ type where n is an integer greater than 1 and where x is greater than 2n+2, characterized in that A is copper and in that the material includes traces of silver.

8. A superconductor material according to claim 7, characterized in that n is greater than or equal to 3.

9. A superconductor material according to claim 7, characterized in that it includes excess calcium and a deficit of barium in application of the formula CuBa_{2-y}Ca_{n-1+y}CuₙOₓ where y lies in the range 0 to 0.5.
